# EUROPEAN PATENT APPLICATION

(11) **EP 2 180 519 A2**
(43) Date of publication of application: **28.04.2010**
(21) Application number: 09173446.7
(22) Date of filing: 19.10.2009
(51) Int. Cl.: H01L 31/0352

(54) **Solar cell having supplementary light-absorbing material and related system and method**

(30) Priority: 23.10.2008 US 257293
(71) Applicant: Honeywell International Inc., Morristown, NJ 07962 (US)
(72) Inventor: Zheng, Zhi, 200030, Shanghai (CN); Tang, Huili, Morristown, NJ 07962-2245 (US); Zhao, Linan, 201204, Shanghai (CN); Wang, Wei Jun, 201102, Shanghai (CN); Wang, Marilyn, 201203, Shanghai (CN); Liu, Xuanbin, 201702, Shanghai (CN)
(74) Representative: Buckley, Guy Julian

(57) **Abstract**

A solar cell (100, 200) includes an electron conductor (102), a plurality of quantum dots (106A-106D) on a surface of the electron conductor forming a quantum dot layer, and a supplemental light-absorbing material in one or more gaps (118) in the quantum dot layer. The supplemental light-absorbing material is capable of absorbing light that passes through the one or more gaps in the quantum dot layer and converting the absorbed light into holes (112) and electrons (110). The supplemental light-absorbing material may also inhibit a hole conductor (104) from coming into contact with the electron conductor. The supplemental light-absorbing material could include one or more polymers, semiconductors, fluorophores, metal particles, nanowires, nanotubes, and nanoparticles. The supplemental light-absorbing material could also include one or more supplementary quantum dots (120) attached to the electron conductor through one or more linkers (122), where electrons generated by the one or more supplementary quantum dots are transferred to the electron conductor through the one or more linkers.

## Description

### TECHNICAL FIELD

This disclosure relates generally to solar cells and, more specifically, to a solar cell having supplementary light-absorbing material and related system and method.

### BACKGROUND

Various types of solar cells have been developed over the years. Within solar cells, absorbed light is often used to generate an exciton (a bound electron-hole pair) that dissociates into a hole and an electron. The electron is injected to an electron conductor, and the hole is transferred to a hole conductor. The hole travels through the hole conductor to a first electrode, and the electron travels through the electron conductor to a second electrode. In this way, the holes and electrons generate electromotive force for supplying power to an external component coupled to the electrodes.

The energy conversion efficiency of a solar cell is often proportional to the product of its injection efficiency, collection efficiency, and light harvesting efficiency. Injection efficiency refers to the percentage of generated electrons that are injected onto the electron conductor. The collection efficiency refers to the percentage of injected electrons that are transported to the second electrode before recombining with holes. The light harvesting efficiency refers to the percentage of light entering the solar cell that is absorbed by materials in the solar cell.

Some conventional solar cells have low energy conversion efficiency due to (among other things) poor coverage of the solar spectrum, small exciton diffusion lengths, and poor charge transport properties. To help reduce or eliminate these or other problems, solar cells can include quantum dots. Quantum dots can improve the energy conversion efficiency of solar cells by helping to dissociate excitons into holes and electrons. Quantum dots can also help to transport electrons to the electrode. Quantum dots can further act as light absorbers, helping to improve solar spectrum coverage of the solar cell.

However, in conventional solar cells, an electron conductor surface typically is not well covered by quantum dots. As a result, some of the light that enters these solar cells passes through gaps in the quantum dot layer without being absorbed, which reduces the light harvesting efficiency. Also, the hole conductor is able to make contact with the electron conductor through gaps in the quantum dot layer, which causes electron-hole recombination at the hole conductor-electron conductor interface. Electron-hole recombination reduces the collection efficiency and, thus, the overall efficiency of these solar cells.

### SUMMARY

This disclosure provides a solar cell having supplementary light-absorbing material and related system and method.

In a first embodiment, a solar cell includes an electron conductor, a plurality of quantum dots on a surface of the electron conductor forming a quantum dot layer, and a supplemental light-absorbing material in one or more gaps in the quantum dot layer. The supplemental light-absorbing material is capable of absorbing light that passes through the one or more gaps in the quantum dot layer and converting the absorbed light into holes and electrons.

In particular embodiments, the supplemental light-absorbing material inhibits a hole conductor from coming into contact with the electron conductor.

In other particular embodiments, the supplemental light-absorbing material comprises one or more light-absorbing dye molecules.

In yet other particular embodiments, the supplemental light-absorbing material comprises one or more supplementary quantum dots attached to the electron conductor through one or more linkers, the one or more linkers configured to transfer electrons generated by the supplementary quantum dots to the electron conductor.

In still other particular embodiments, the supplemental light-absorbing material comprises at least one of polymers, semiconductors, fluorophores, metal particles, nanowires, nanotubes, and nanoparticles.

In a second embodiment, a system includes a solar cell and circuitry configured to receive power from the solar cell. The solar cell includes an electron conductor and a plurality of quantum dots on a surface of the electron conductor forming a quantum dot layer. The solar cell also includes a supplemental light-absorbing material in one or more gaps in the quantum dot layer. The supplemental light-absorbing material is capable of absorbing light through the gaps in the quantum dot layer. The solar cell further includes a hole conductor and two or more electrodes providing an electrical connection to the solar cell. Excitons photo-generated in the plurality of quantum dots and the supplemental light-absorbing material dissociate into holes and electrons. The electron conductor transports at least some of the electrons towards a first of the electrodes.

In a third embodiment, a method includes forming an electron conductor having a surface. The method also includes synthesizing a plurality of quantum dots on the surface of the electron conductor to form a quantum dot layer. The method further includes depositing a supplemental light-absorbing material into one or more gaps in the quantum dot layer. In addition, the method includes forming a hole conductor over the quantum dot layer and the supplemental light-absorbing material. The supplemental light-absorbing material is capable of absorbing light that passes through the one or more gaps in the quantum dot layer and converting the absorbed light into holes and electrons.

Other technical features may be readily apparent to one skilled in the art from the following figures, descriptions, and claims.

### BRIEF DESCRIPTION OF THE DRAWINGS

For a more complete understanding of this disclosure, reference is now made to the following description, taken in conjunction with the accompanying drawings, in which:

FIGURE 1 illustrates a first example solar cell having supplementary light-absorbing material according to this disclosure;

FIGURE 2 illustrates a second example solar cell having supplementary light-absorbing material according to this disclosure;

FIGURE 3 illustrates an example circuit containing a solar cell having supplementary light-absorbing material according to this disclosure; and

FIGURE 4 illustrates an example method for forming a solar cell having supplementary light-absorbing material according to this disclosure.

### DETAILED DESCRIPTION

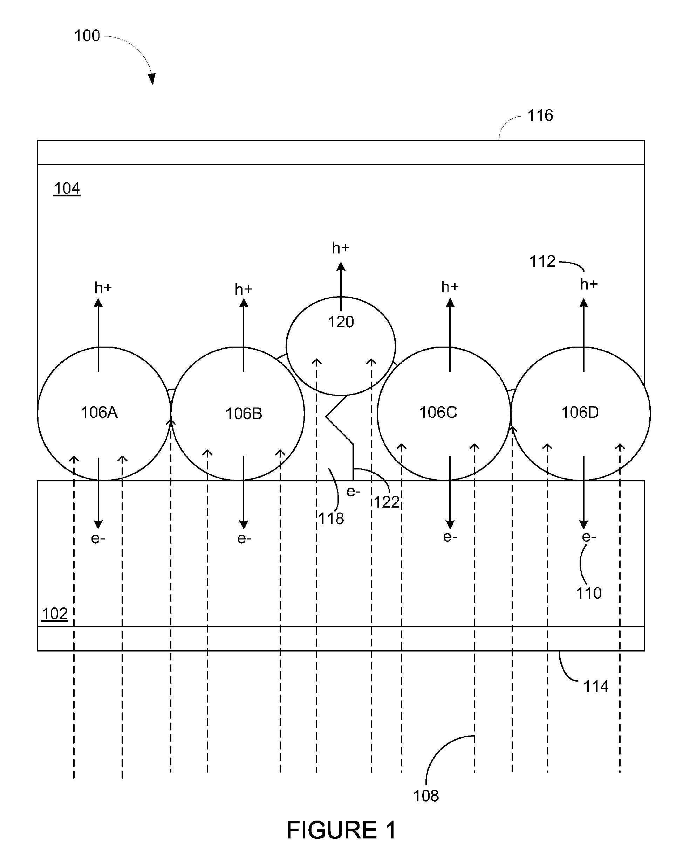

FIGURES 1 through 4, discussed below, and the various embodiments used to describe the principles of the present invention in this patent document are by way of illustration only and should not be construed in any way to limit the scope of the invention. Those skilled in the art will understand that the principles of the invention may be implemented in any type of suitably arranged device or system.

FIGURE 1 illustrates a first example solar cell 100 having supplementary light-absorbing material according to this disclosure. The embodiment of the solar cell 100 shown in FIGURE 1 is for illustration only. Other embodiments of the solar cell 100 could be used without departing from the scope of this disclosure.

As shown in FIGURE 1, the solar cell 100 has an electron conductor 102, a hole collector 104, and a plurality of quantum dots 106A-106D. At least some light 108 entering the electron conductor 102 is absorbed by the quantum dots 106A-106D. The quantum dots 106A-106D convert the absorbed light into electrons (e⁻) 110 and holes (h⁺) 112. The electrons 110 are injected into the electron conductor 102 where the electrons 110 travel across the electron conductor 102 towards a first electrode 114. The holes 112 are injected into the hole conductor 104 where the holes 112 travel across the hole conductor 104 towards a second electrode 116. The movement of the electrons 110 and the holes 112 across the electron conductor 102 and the hole conductor 104, respectively, generates an electromotive force, which is used to supplying power to an external component coupled to the first and second electrodes 114 and 116.

The solar cell 100 also has a gap 118 in the coverage of the electron conductor 102 between the quantum dots 106B and 106C. Rather than allowing light to pass through the gap 118 and allowing the hole conductor 104 to come into contact with the electron conductor 102 at the gap 118, the solar 100 further includes a supplementary light-absorbing material to absorb the part of the light 108 that passes through the gap 118. In the embodiment shown in FIGURE 1, the supplementary light-absorbing material takes the form of a supplementary quantum dot 120, which is attached to the electron conductor 102 by a linker 122.

The supplementary quantum dot 120 absorbs the part of the light 108 that passes through the gap 118 and converts the absorbed light into additional electrons 110 and holes 112. The electrons 110 generated by the supplementary quantum dot 120 are transferred to the electron conductor 102 via the linker 122, and the holes 120 generated by the supplementary quantum dot 120 are injected into the hole conductor 104. Accordingly, the supplementary quantum dot 120 increases the energy conversion efficiency of the solar cell 100 by (i) absorbing light that would have otherwise passed through the solar cell 100 and (ii) preventing the hole conductor 104 from coming into contact with the electron conductor 102, which would otherwise cause recombination of electron 110 with hole 112 and lower the cell efficiency. Like the quantum dots 106A-106D, the supplementary quantum dot 120 can also help to dissociate excitons into holes and electrons.

Although the supplementary light-absorbing material in the solar cell 100 is depicted as a supplementary quantum dot 120 in FIGURE 1, the supplementary light-absorbing material in the solar cell 100 could have any other suitable form. For example, the supplementary light-absorbing material could take the form of any suitable material or combination of materials (for example, inorganic materials or macromolecular organic materials such as polymers) that functionalizes the uncovered surfaces of the electron conductor 102 by facilitating light absorption, charge separation and conduction in the solar cell 100. As particular examples, the supplementary light-absorbing material could include nanowires, nanotubes, or nanoparticles. Note that these represent example forms for the supplementary light-absorbing material. The supplementary light-absorbing material could have one or more of these forms or any other or additional form(s).

In some embodiments, the supplementary light-absorbing material and the quantum dots 106A-106D could represent the same inorganic material. In other embodiments, the quantum dots 106A-106D and the supplementary light-absorbing material could represent different inorganic materials. As a particular example, the quantum dots 106A-106D could represent quantum dots of cadmium selenide (CdSe), and the supplementary light-absorbing material could represent nanoparticles or quantum dots of lead selenide (PBSe). In such an embodiment, the quantum dots 106A-106D absorbs visible light, while the supplementary light-absorbing material absorbs infrared light that cannot be absorbed by the quantum dots 106A-106D. Accordingly, inorganic materials different from those of the quantum dots 106A-106D can be used as the supplementary light-absorbing material to extend the coverage of the solar spectrum, increasing the solar cell's ability to harvest light in a wider range of frequencies.

The electron conductor 102 represents any suitable material or combination of materials used as an acceptor material in a solar cell, such as one or more inorganic or organic materials. For example, the electron conductor 102 could include nanocrystalline Ti02, Ti02 nanotubes, ZnO nanowires, carbon nanotubes, metal film or nanowires covered by semiconductor layers, poly[oxa-1,4-phenylene-1,2-(1-cyano)-ethenylene-2,5 dioctyloxy-1,4-phenylene-1,2-(2-cyano)-ethenylene-1,4-phenylene] (also called "CN-ether-PPV") or 1-(3-methoxycarbonyl)-propyl-1-phenyl-(6,6)C₆₁ (also called "PCBM") .

The hole conductor 104 represents any suitable material or combination of materials used as a donor material in a solar cell, such as one or more inorganic or organic materials. For example, the hole conductor 104 could include poly(methoxy-ethylexyloxy-phenylenevinilene) (also called "MEH-PPV") or poly(3-hexylthiophene) (also called "P3HT"), or semiconductors such as CuSCN, CuI, or ionic liquid, ionic liquid gel, and melting salts.

The first and second electrodes 114 and 116 provide an electrical connection to the solar cell 100. For example, one or more additional electrical components can be coupled to the first and second electrodes 114 and 116 and powered by the solar cell 100. In this example, the first electrode 114 collects the electrons 110, and the second electrode 116 collects the holes 112. Each of the first and second electrodes 114 and 116 includes any suitable material or combination of materials providing an electrical connection. Various example materials include titanium, silver, gold, copper, tin oxide (SnO₂), or indium tin oxide (ITO) .

In this example, the light 108 strikes the solar cell 100 on the bottom of the solar cell 100 in FIGURE 1. In this embodiment, the first electrode 114 could be formed from tin oxide, indium tin oxide, or other transparent material(s). It may be noted that the light 108 could strike the solar cell 100 in any other or additional location(s). For example, the light 108 could strike the solar cell 100 on the top of the solar cell 100 in FIGURE 1. In that embodiment, the second electrode 116 could be formed from tin oxide, indium tin oxide, or other transparent material(s).

Although FIGURE 1 illustrates a first example solar cell 100 having supplementary light-absorbing material, various changes may be made to FIGURE 1. For example, the solar cell 100 could include any number of quantum dots 106A-106D, gaps 118, supplementary quantum dots 120, and linkers 122. Also, the supplementary quantum dots 120 could be located in any number of places within the solar cell 100. Further, the electron conductor 102 and the hole collector 104 could have any suitable size and shape.

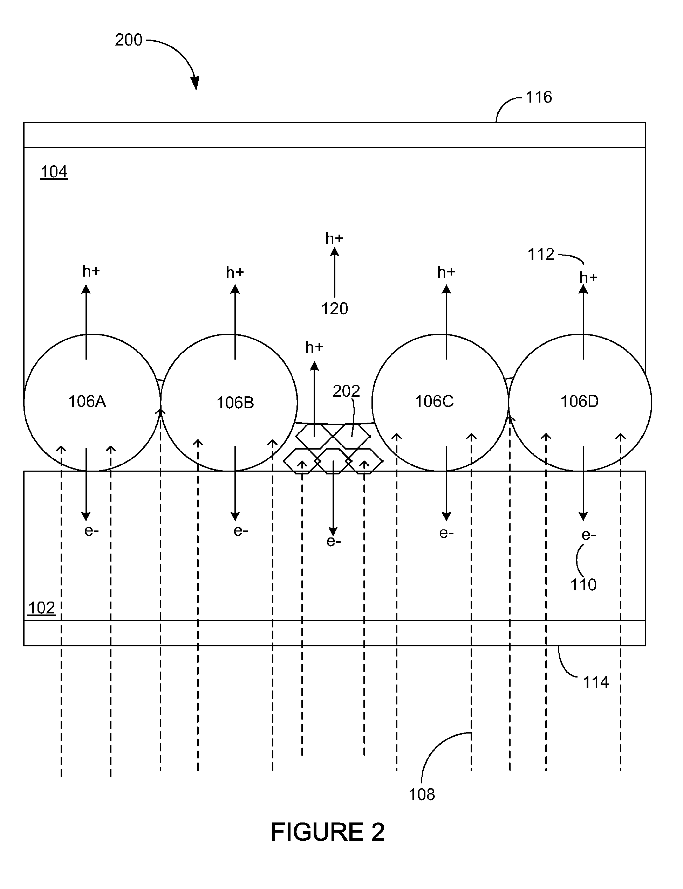

FIGURE 2 illustrates a second example solar cell 200 having supplementary light-absorbing material according to this disclosure. The embodiment of the solar cell 200 shown in FIGURE 2 is for illustration only. Other embodiments of the solar cell 200 could be used without departing from the scope of this disclosure.

As shown in FIGURE 2, the second cell 200 includes components that are the same as or similar to corresponding components in FIGURE 2. In the embodiment shown in FIGURE 2, the supplementary light-absorbing material takes the form of light-absorbing dye molecules 202 or other light-absorbing small organic moledules such as fluorophore. The light-absorbing dye molecules 202 could be, for example, a ruthenium metalorganic dye, although the light-absorbing dye molecules 202 could represent any suitable dye or combination of dyes that functionalizes the uncovered surfaces of the electron conductor 102 by facilitating light absorption, charge separation, and conduction in the solar cell 200.

Like the supplementary quantum dot 120, the light-absorbing dye molecules 202 absorb the part of the light 108 that passes through the gap 118 and converts the absorbed light into additional electrons 110 and holes 112. The electrons 110 generated by the light-absorbing dye molecules 202 are transferred to the electron conductor 102, and the holes 112 generated by the light-absorbing dye molecules 202 are injected into the hole conductor 104.

Accordingly, the light-absorbing dye molecules 202 increase the energy conversion efficiency of the solar cell 100 by (i) absorbing light that would have otherwise passed through the solar cell 200 and (ii) preventing the hole conductor 104 from coming into contact with the electron conductor 102, which would otherwise cause recombination of electron 110 with hole 112 and lower the cell efficiency. Furthermore, the light-absorbing dye molecules 202 can be selected of a material or materials that extend the coverage of the solar spectrum, increasing the solar cell's ability to harvest light in a wider range of frequencies.

Although FIGURE 2 illustrates a second example solar cell 200 having supplementary light-absorbing material, various changes may be made to FIGURE 1. For example, the solar cell 200 could include any number of quantum dots 106A-106D, gaps 118, and light-absorbing dye molecules 202. Also, the light-absorbing dye molecules 202 could be located in any number of places within the solar cell 200. Further, the electron conductor 102 and the hole collector 104 could have any suitable size and shape.

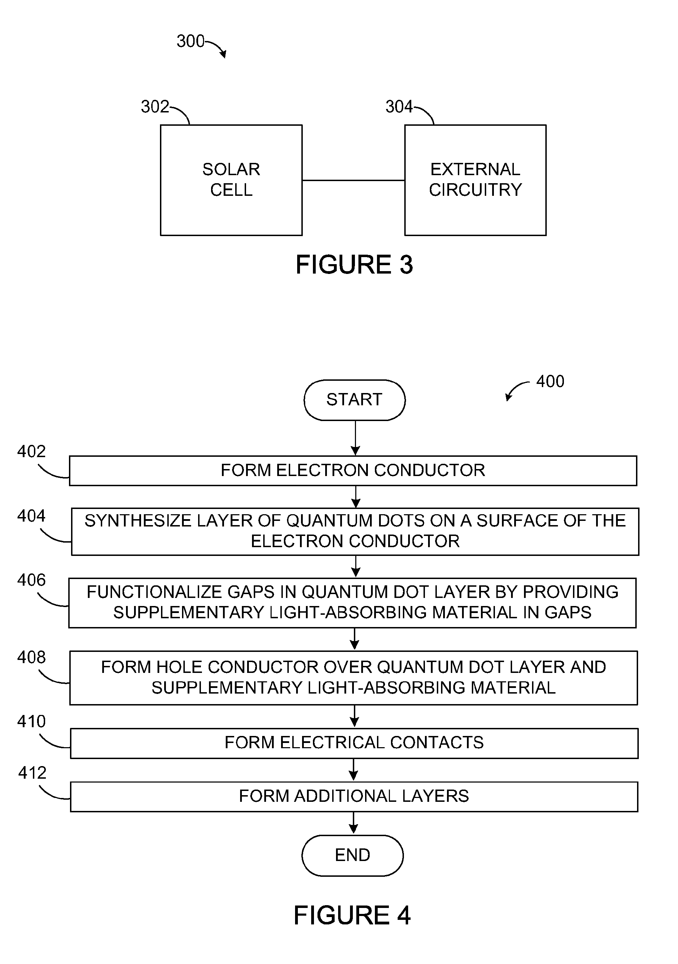

FIGURE 3 illustrates an example circuit 300 containing a solar cell having supplementary light-absorbing material according to this disclosure. The circuit 300 shown in FIGURE 3 is for illustration only. Other circuits could use the solar cells described above without departing from the scope of this disclosure.

In this example, a solar cell 302 is coupled to external circuitry 304. The solar cell 302 could represent any suitable solar cell having supplementary light-absorbing material. The solar cell 302 could, for example, represent one or more of the solar cells 100 and 200 described above.

The external circuitry 304 represents any suitable circuitry for using power provided by the solar cell 302. For example, the external circuitry 304 could represent a photovoltaic device, a photo-sensor, or a photo-catalysis system. The external circuitry 304 could also represent circuitry that performs monitoring or reporting functions in a wireless asset tag. Furthermore, the external circuitry 304 could represent circuitry that performs monitoring or control functions in an industrial processing environment. The external circuitry 304 could further represent circuitry that uses the power from the solar cell 302 to recharge a battery or other power source. The external circuitry 304 could perform any other or additional functionality according to particular needs. At least part of the power used by the external circuitry 304 is provided by the solar cell 302.

Although FIGURE 3 illustrates an example circuit 300 containing supplementary light-absorbing material, various changes may be made to FIGURE 3. For example, the circuit 300 could include any number of solar cells 302 and external circuitry 304. Also, the solar cells 100 and 200 described above could be used in any other suitable manner.

FIGURE 4 illustrates an example method 400 for forming a solar cell having supplementary light-absorbing material according to this disclosure. The method 400 shown in FIGURE 4 is for illustration only. Solar cells could be manufactured in any other suitable manner without departing from the scope of this disclosure.

An electron conductor is formed from any suitable material or combination of materials at step 402. This could include, for example, using at least one inorganic or organic material as an acceptor material in a solar cell. The electron conductor could be formed in any suitable manner, such as by depositing a layer of organic material on a temporary substrate or a layer of material forming an electrode.

At step 404, a layer of quantum dots is synthesized on the surface of the electron conductor. The quantum dots could be synthesized in any suitable manner. As a particular example, this could include depositing cadmium selenide quantum dots onto the surface of the electron conductor.

In step 406, gaps in the quantum dot layer are functionalized by providing supplementary light-absorbing material in the gaps of the quantum dot layer. In some embodiments, the supplementary light-absorbing material may take the form of supplemental quantum dots. In this case, bi-functional linkers are added to the gaps of the quantum dot layer. Linkers are small molecules that can enter the gaps in the quantum dot layer and bind at a first end with the electron conductor to form a monolayer. Supplementary quantum dots are then bound to the second end of the linkers. Of course, the supplementary quantum dots could be bound to the second end of the linkers before binding the first end of the linkers to the electron conductor. In other embodiments, the supplementary light-absorbing material may take the form of light-absorbing dye molecules. In this case, the light-absorbing dye molecules are added to the gaps in the quantum dot layer in any suitable manner. Note that the supplementary light-absorbing material may take any other or additional form(s).

A hole conductor is formed over the layer of quantum dots and the supplementary light-absorbing material at step 408. This could include, for example, using at least one organic material as a donor material in the solar cell. The hole conductor could be formed in any suitable manner, such as by depositing a layer of organic material over the layer of quantum dots and the supplementary light-absorbing material. The presence of the supplementary light-absorbing material reduces or eliminates contact of the hole conductor with the electron conductor.

Electrical contacts for the solar cell are formed at step 410. This could include, for example, depositing one or more layers of metal or other conductive material(s) to form each electrical contact. This could also include attaching a cover, substrate, or other structure carrying an electrical contact to the other structures of the solar cell. Note that at least one of the electrical contacts could have been formed earlier, such as when one electrode is formed prior to step 402 and the electron conductor is formed on that electrode.

Any additional layers are formed at step 414. This could include, for example, forming transparent covers or other protective layers in the solar cell. Note that one or more additional layers could also be formed earlier in the method 400, such as when a buffer layer is formed prior to the formation of an electrical contact.

Although FIGURE 4 illustrates an example method 400 for forming a solar cell having supplemental light-absorbing material, various changes may be made to FIGURE 4. For example, while shown as a series of steps, various steps in FIGURE 4 could overlap, occur in parallel, occur in a different order, or occur multiple times.

It may be advantageous to set forth definitions of certain words and phrases used throughout this patent document. The term "couple" and its derivatives refer to any direct or indirect communication between two or more elements, whether or not those elements are in physical contact with one another. The terms "include" and "comprise," as well as derivatives thereof, mean inclusion without limitation. The term "or" is inclusive, meaning and/or. Terms such as "over" and "under" refer to relative positions in the figures and do not denote required orientations during manufacturing or use. The phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like.

While this disclosure has described certain embodiments and generally associated methods, alterations and permutations of these embodiments and methods will be apparent to those skilled in the art. Accordingly, the above description of example embodiments does not define or constrain this disclosure. Other changes, substitutions, and alterations are also possible without departing from the spirit and scope of this disclosure, as defined by the following claims.

## Claims

1. A solar cell (100, 200) comprising:
an electron conductor (102);
a plurality of quantum dots (106A-106D) on a surface of the electron conductor forming a quantum dot layer; and
a supplemental light-absorbing material in one or more gaps (118) in the quantum dot layer;
wherein the supplemental light-absorbing material is capable of absorbing light that passes through the one or more gaps in the quantum dot layer and converting the absorbed light into holes (112) and electrons (110).

2. The solar cell of Claim 1, wherein the supplemental light-absorbing material inhibits a hole conductor (104) from coming into contact with the electron conductor.

3. The solar cell of Claim 1, wherein the supplemental light-absorbing material comprises one or more light-absorbing dye molecules (202).

4. The solar cell of Claim 1, wherein the supplemental light-absorbing material comprises one or more supplementary quantum dots (120) attached to the electron conductor through one or more linkers (122), the one or more linkers configured to transfer electrons generated by the supplementary quantum dots to the electron conductor.

5. The solar cell of Claim 1, wherein the supplemental light-absorbing material comprises at least one of polymers, semiconductors, fluorophores, metal particles, nanowires, nanotubes, and nanoparticles.

6. A system (300) comprising a solar cell (302) and circuitry (304) configured to receive power from the solar cell, the solar cell comprising:
an electron conductor (102);
a plurality of quantum dots (106A-106D) on a surface of the electron conductor forming a quantum dot layer;
a supplemental light-absorbing material in one or more gaps (118) in the quantum dot layer, the supplemental light-absorbing material capable of absorbing light through the gaps in the quantum dot layer;
a hole conductor (104); and
two or more electrodes (114-116) providing an electrical connection to the solar cell;
wherein excitons photo-generated in the plurality of quantum dots and the supplemental light-absorbing material dissociate into holes (112) and electrons (110); and
wherein the electron conductor transports at least some of the electrons towards a first of the electrodes.

7. The system of Claim 6, wherein the hole conductor is configured to transport at least some of the holes towards a second of the electrodes.

8. The system of Claim 6, wherein the supplemental light-absorbing material inhibits the hole conductor from coming into contact with the electron conductor.

9. A method comprising:
forming (402) an electron conductor (102) having a surface;
synthesizing (404) a plurality of quantum dots (106A-106D) on the surface of the electron conductor to form a quantum dot layer;
depositing (406) a supplemental light-absorbing material into one or more gaps (118) in the quantum dot layer; and
forming (408) a hole conductor (104) over the quantum dot layer and the supplemental light-absorbing material;
wherein the supplemental light-absorbing material is capable of absorbing light that passes through the one or more gaps in the quantum dot layer and converting the absorbed light into holes (112) and electrons (110).

10. The method of Claim 9, further comprising:
forming (410) two or more electrodes (114-116), a first of the electrodes configured to receive at least some of the holes, a second of the electrodes configured to receive at least some of the electrons.
